# EUROPEAN PATENT SPECIFICATION

(11) **EP 2 392 932 B1**
(45) Date of publication and mention of the grant of the patent: **03.12.2014**
(21) Application number: 10164888.9
(22) Date of filing: 03.06.2010
(51) Int. Cl.: H04B 17/00, G01R 29/08, H04M 1/24

(54) **System and method for verifying a device under test**
System und Verfahren zur Verifizierung einer zu prüfenden Vorrichtung
Système et procédé de vérification d'un dispositif sous test

(43) Date of publication of application: 07.12.2011
(73) Proprietor: BlackBerry Limited, Waterloo, ON N2K 0A7 (CA)
(72) Inventor: Gordiyenko, Anatoliy, Waterloo Ontario N2L 3W8 (CA); Skarine, Alexei, Waterloo Ontario N2L 3W8 (CA); Kalantari, Rahi, Waterloo Ontario N2L 3W8 (CA)
(74) Representative: Noble, Nicholas

(56) References cited:
- EP-A1- 1 223 432
- WO-A2-2008/031112
- JP-A- 11 038 055
- US-A1- 2005 255 839
- US-A1- 2007 239 877

## Description

### FIELD

This disclosure, in a broad sense, is directed toward a system, method and apparatus for verifying the operation of a wireless device. More specifically, this disclosure relates to reducing interference during testing of wireless devices.

### BACKGROUND

With the proliferation of wireless communication systems, compatible handheld communication devices are becoming more prevalent, as well as advanced. During development, these devices need to be verified to ensure that, for example, these devices are operating correctly, and these devices comply with radio frequency (RF) requirements, such as Federal Communications Commission (FCC) requirements.

Currently, wireless systems are commonly tested in an anechoic shielded testing chamber to prevent outside RF signals from interfering with the testing and prevent interference from signal reflection inside the shielded testing chamber. A radio antenna for receiving signals can be located inside or near the anechoic shielded testing chamber to send and receive signals to and from a device under test (DUT), such as a cellular phone. Additionally, a test controller can communicate with the DUT via a communication cable to control the test or obtain testing information. By using the communication cable, the DUT can be run through a series of tests to verify the DUT's operation and ensure compliance with appropriate regulatory or operational standards.

EP 1223432 details a chamber for processing electronic devices, the chamber is adapted for handling several devices simultaneously and said processing comprises a transfer of airborne signals. This allows a simultaneous test under controlled and homogeneous conditions.

WO 2008/031112 details a radiated testing module that executes a predetermined radiated performance test on a wireless device. The test dictates various performance-related parameters to measure and log at each of a plurality of predetermined positions. Further, the wireless device receives synchronization information operable to enable synchronization between the logged measurements and each of the positions. The synchronized log allows the wireless device, or another apparatus, to determine a radiated performance characteristic based on a predetermined analysis protocol.

JP 11038055 is directed to characterising wireless device performance in a manner that prevents interference between a signal received by the wireless device and that transmitted thereby. In particular, transmitting antennas are arranged in a sealed box along with a wireless device and the electromagnetic field of a signal which is transmitted from the transmitting antennas and received by the device is determined. The device is provided with means for transmitting, as a optical signal, an information signal about the strength of the received electric field, and an optical sensor for receiving the information signal is provided in the sealed box.

US 2007/239877 is directed to the provision of a function setting system, and a function setting method, that can easily and efficiently perform accurate setting and simultaneously perform setting for plural devices even when a large number of parameters have to be accurately set the same among devices that perform communication with one another. A setting object machine displays communication setting for provisional connection as an image pattern using an image-pattern display unit. A setting machine photographs the image pattern using an imaging device and analyzes the image pattern using an imageinformation analyzing unit to deduce setting of the setting machine necessary for communicating with the setting object machine. The setting machine generates setting information of a desired network using a regular-connection individual-setting generating unit. The setting machine transmits the setting information of the network generated to the setting object machine through a communication path established in a one-to-one relation.

### BRIEF DESCRIPTION OF THE DRAWINGS

Implementations of the present application will now be described, by way of example only, with reference to the attached Figures, wherein:
Figure 1 is block diagram of a testing environment in accordance with an exemplary implementation;
Figure 2 is a front view of a DUT displaying a barcode in accordance with an exemplary implementation;
Figure 3 is a front view of a DUT displaying a QR in accordance with an exemplary implementation;
Figures 4A-4D are exemplary barcodes representing test information that can be transmitted or received by a DUT in accordance with an exemplary implementation;
Figure 5 is back view of a DUT in accordance with an exemplary implementation;
Figure 6 is a block diagram representing a mobile communication device interacting in a communication network in accordance with an exemplary implementation; and
Figure 7 is a flowchart of a method for verifying the operation of a DUT in accordance with an exemplary implementation.

### DETAILED DESCRIPTION

Aspects and features of the present subject matter are set out in the appended claims.

It will be appreciated that for simplicity and clarity of illustration, where appropriate, reference numerals have been repeated among the different figures to indicate corresponding or analogous elements. In addition, numerous specific details are set forth in order to provide a thorough understanding of the implementations described herein. However, it will be understood by those of ordinary skill in the art that the implementations described herein can be practiced without these specific details. In other instances, methods, procedures and components have not been described in detail so as not to obscure the related relevant feature being described. Also, the description is not to be considered as limiting the scope of the implementations described herein.

Several definitions that apply throughout this disclosure will now be presented. The word "communicatively coupled" is defined as connected, whether directly or indirectly through intervening components and is not necessarily limited to physical connections. The term "mobile device" is defined as any electronic device that is capable of at least accepting information entries from a user and includes a device's own power source. The term "optical spectrum" means light that has a frequency of approximately 380 nanometers (nm) up to about 750 nm. The term "infrared spectrum" means light that has a frequency of approximately 750 nanometers (nm) up to about 1 millimeter (mm). The term "ultraviolet spectrum" means light that has a frequency of approximately 10 nm up to about 380 nm. A "wireless communication" means communication that occurs without wires using electromagnetic radiation.

The terms "processor" and "processing unit" are defined as a component or a group of components that are capable of receiving input signals, such as those associated with movement at or on an optical trackpad or other data, processing those signals and selectively signaling other components to respond to such movements. A "shielded testing chamber" is defined as a chamber that isolates the interior of a testing chamber from external electromagnetic interference. A "detector" is defined as an apparatus that senses information that is received via, for example an antenna or optical detector such as a barcode scanner or camera.

In accordance with examples described herein, a user can define one or more test cases to test connectivity, software applications or other aspects of a test device. A test case can comprise a series of test steps that have one or more validation criteria and one or more pass or fail steps that can determine a test case result. For example, a wireless antenna can be tested to ensure that the operation of the wireless antenna fits within allowable tolerances. Parameters that can be tested can include gain, beamwidth, bandwidth, polarization, input impedance, radiation efficiency, directivity, and radiation pattern. The operation of a DUT can then be compared with predetermined values to determine whether the DUT passes a verification test. For example, signal strength can be compared to a predetermined value of expected signal strength to determine whether the DUT passed a test. Another exemplary implementation compares information sent to the DUT over a first wireless frequency with information retransmitted back to a computer via a second wireless frequency. The information can be, for example, a predetermined sequence of characters that is transmitted to the DUT via a first wireless communication and read back via a second wireless communication with the first wireless communication and second wireless communication operating at different frequencies. The transmitted and received values can be compared to determine whether the test was passed. Other known tests can be run but are not discussed in detail for brevity. The DUT can be any of the following: a personal digital assistant (PDA), a handheld electronic device, a non-handheld wireless communication device, a pager, a cellular phone, a cellular smart-phone, a wireless organizer, a wirelessly enabled notebook computer and the like or any other device designed to transmit electromagnetic radiation.

It has been found that materials used in testing environments can cause inaccurate test results due to interference and parasitic signal absorption from conductive materials within the testing chamber, for example, wires and other electronic devices. These conductive materials tend to absorb radiation transmitted to and from the antenna, and the conductive materials can generate radiation from signals transmitted on the conductive materials, which can skew test results. Even a relatively small variation in a test result can yield a false positive, leading to shipment of a non-conforming part or product, or false negative leading to additional cost to remedy a non-existent problem. Therefore, preventing false positive test passes and false negative test failures is important because preventing false positive test passes and false test failures can lead to increased quality, reliability, and lower costs.

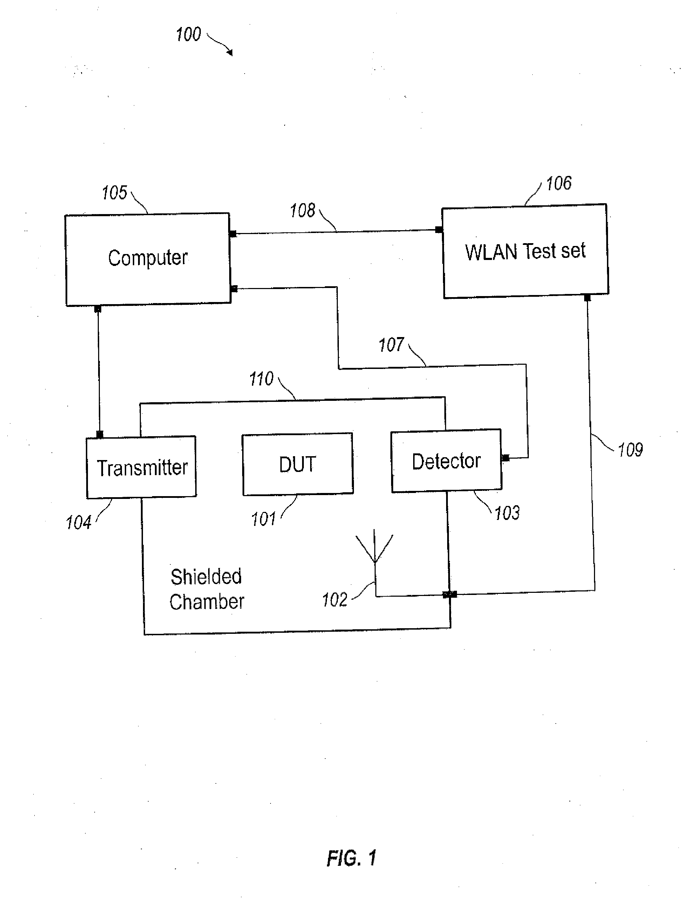

Figure 1 illustrates a testing system 100 in which a device under test (DUT) 101 is arranged inside of anechoic or a shielded testing chamber 110. The shielded testing chamber 110 can include one or more radiation absorbent materials that absorb electromagnetic signals generated by the DUT 101, thereby reducing reflection of the signals within the testing system 100. Absorbing the electromagnetic signals can help to reduce interference in the testing system 100. A test antenna 102 can receive the signals from the DUT 101 and can transmit the signals to a test set 106 or a computer 105 via cables 109 and 108. The test antenna 102 can also transmit information to the DUT 101 in a test simulating real-world communication between, for example, a cellular phone and a cellular antenna. In addition, a detector 103 can communicate with the DUT 101 to transmit information via signals, for example, optical signals, to the detector 103, which in turn, can transmit the information to the computer 105 via the cable 107. The information sent from the DUT 101 to the detector 103, can be, for example, status information and operational parameters. Status information can include which step of the test is being executed or when testing begins or ends. Operational parameters can include operating frequency, signal strength and battery strength. Additional information can be transmitted to the DUT 101 via a transmitter 104, which can transmit information via signals, for example, optical or infrared, that will not interfere with the signals generated by the DUT 101. The transmitted information can include, for example, test instructions or requests for information to be communicated to the detector 103. In other implementations, the transmitter 104 and the detector 103 can be integrated into a single device, or the detector 103 may be able to both send and receive information wirelessly, such as optical, infrared or ultraviolet barcodes, infrared signal, or signals in other wireless spectra, with DUT 101.

In an implementation in which transmitter 104 and detector 103 are integrated into a single device, DUT 101 can both send and receive additional information outside the chamber via the integrated device. As discussed throughout this disclosure, the additional information is sent wirelessly. Integrating transmitter 104 and detector 103 can save costs because there will be fewer discrete components to place into the testing system.

Using preexisting hardware on the DUT 101 to transmit and receive the additional information can be advantageous. For example, in an implementation when the DUT 101 is a mobile device, the display of the mobile device can be used to transmit additional information using a barcode or quick response "QR" code. Using the display to transmit additional information can be beneficial because detector 103 can be a standard barcode reader or camera that is widely available on the market. Barcode information obtained by the detector 103 can be forwarded to the computer 105 for processing during a verification test. In another example, some devices have multiple outputs, for example, infrared port, projector, or an LCD panel, that can be used in accordance with this disclosure. Using preexisting hardware to aid in testing the DUT 101 reduces cost by utilizing already available hardware and reduces complexity because other interfaces do not have to be added to the DUT 101 to transmit information. In addition, using preexisting hardware can be advantageous because, as explained above, additional conductive material can degrade the testing environment; however, it may still be better to add supplemental hardware, such as an auxiliary display, to the testing environment than include a wire to connect the DUT 101 to the computer 105. The auxiliary display can communicate with DUT 101 wirelessly using methods similar to those used to communicate data between DUT 101 and computer 105 discussed herein.

In still further implementations, the DUT 100 can comprise a touch screen. Utilization of a touch screen within the DUT 100 can be advantageous due to the relatively large screen size possible because an on-screen soft keyboard can replace a physical keypad. The larger screen size makes possible a larger bar code, which assists the detector 103 to detect the barcode 208 correctly.

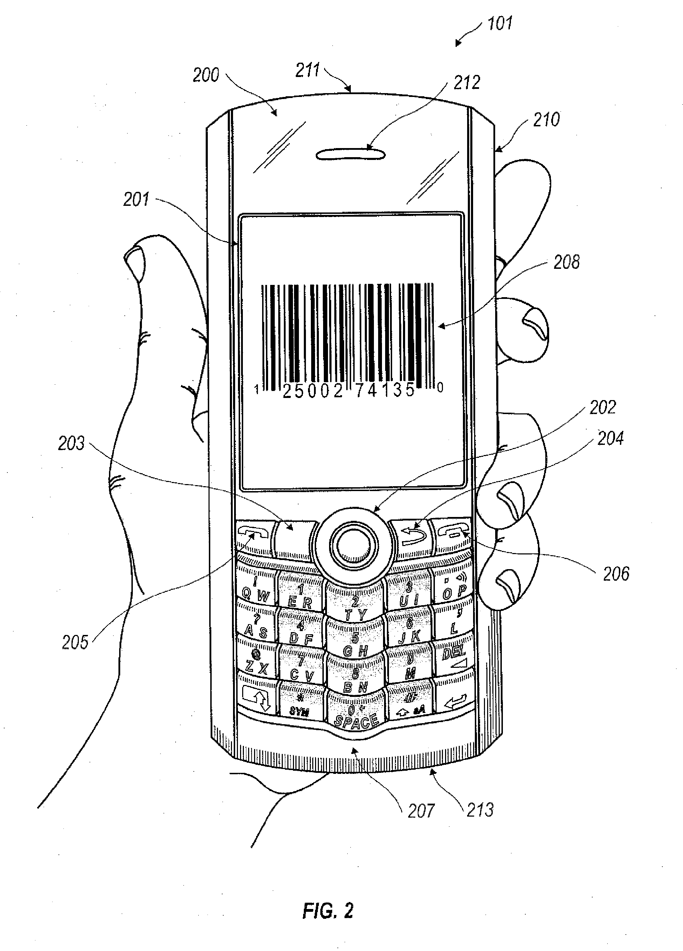

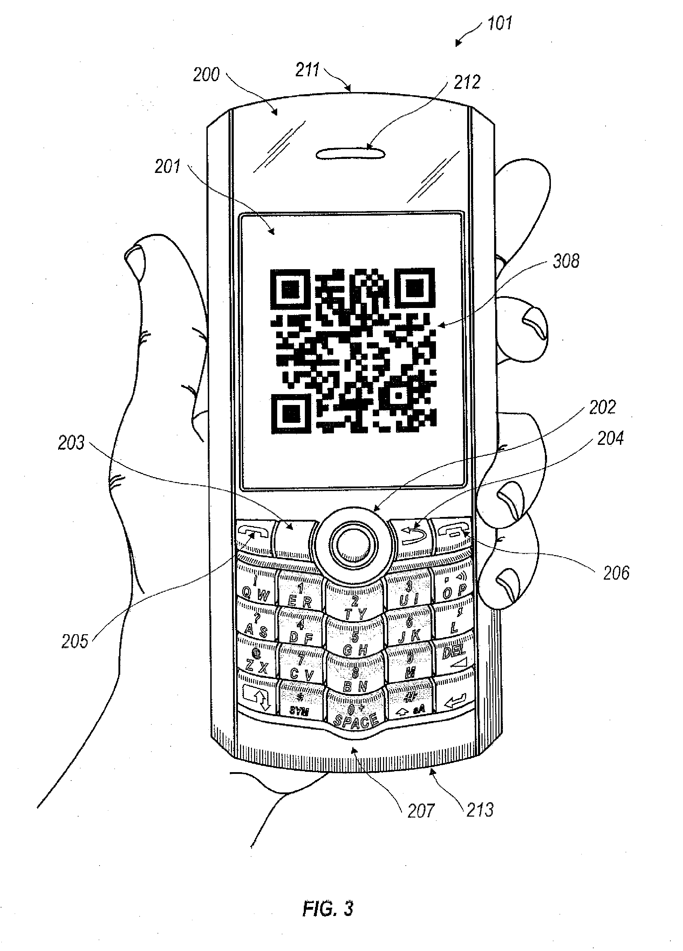

Referring to Figures 2 and 3, front views of the DUT 101 are illustrated A front surface 200 can comprise a display 201, which can be a touch screen that can allow a user to input or select displayed information. The DUT 101 can further include a directional-navigation input 202, which can be a trackball, joystick, optical joystick, or the like. The DUT 101 can also include navigation buttons 203 and 204 that when selected can be used to, for example, display a menu or go back to a previous menu. A call button 205 and an end button 206 can also be included to have physical buttons for making, receiving and ending phone calls. The DUT 101 can still further include a keypad 207 that can include a keyfield having alphanumeric keys arranged in a keyboard layout, numeric keys, and other function keys. In some implementations, the keyboard 207 can be replaced with a software-implemented keypad that can appear on the display 201. The DUT 101 can include front surface 200 and a side surface 210 that can be substantially perpendicular to the front surface 200. As can be seen in example shown in Figures 2 and 3, the front surface 200 can include the display 201 and the keypad 207, although the display 201 and the keypad 207 may be positioned on other surfaces of the DUT 100, if so desired.

Front views of the DUT 100 illustrated in Figures 2 and 3 have a reduced QWERTY keyboard and a full QWERTY keyboard 207, respectively. As shown, the DUT 100 can have a QWERTY keyboard capable of incorporating a messaging application in accordance with exemplary implementations. Each key of the keyboard 207 can be associated with at least one indicia representing an alphabetic character, a numeral, or a command (such as a space command, return command, or the like). The plurality of keys of the keyboard 207 having alphabetic characters is arranged in a standard keyboard layout. The standard keyboard layout can be a QWERTY layout (shown in Figures 2 and 3), a QZERTY layout, a QWERTZ layout, an AZERTY layout, a Dvorak layout, a Russian keyboard layout, a Chinese keyboard layout, or other similar layout. These standard layouts are provided by way of example and other similar standard layouts are considered within the scope of this disclosure. The keyboard layout can be based on the geographical region in which the handheld device is intended for sale. In some examples, the keyboard can be interchangeable such that the user can switch between layouts. In other examples, the keyboard is a virtual keyboard provided on a touch screen display (not shown).

The keyboard or key field 207 can include a plurality of keys that can be of a physical nature such as actuable buttons, or, as mentioned above, they can be of a software nature, typically constituted by virtual representations of physical keys on a display 201 (referred to herein as "virtual keys"). It is also contemplated that the user input can be provided as a combination of the two types of keys. Each key of the plurality of keys has at least one actuable action, which can be the input of a character, a command or a function. When each key of the plurality of keys has at least one actuable action, which can be the input of a character, a command or a function, "characters" are contemplated to exemplarily include alphabetic letters, language symbols, numbers, punctuation, insignias, icons, pictures, and even a blank space. The keys can be alphanumeric keys.

In the case of virtual keys, the indicia for the respective keys are shown on the display 201, which in one implementation is enabled by touching the display 201, for example, with a stylus, finger, or other pointer, to generate the character or activate the indicated command or function. Some examples of the display 201 capable of detecting a touch include resistive, capacitive, projected capacitive, infrared and surface acoustic wave (SAW) touch screens.

Physical and virtual keys can be combined in many different ways as appreciated by those skilled in the art. In one implementation, physical and virtual keys are combined such that the plurality of enabled keys for a particular program or feature of the DUT 101 is shown on the display 201 in the same configuration as the physical keys. When physical and virtual keys are combined such that the plurality of enabled keys for a particular program or feature of the DUT 101 is shown on the display in the same configuration as the physical keys, the operator can select the appropriate physical key corresponding to what is shown on the display 201. Thus, the desired character, command or function is obtained by depressing the physical key corresponding to the character, command or function displayed at a corresponding position on the display 201, rather than touching the display 201.

In at least one implementation, the DUT 101 is configured to send and receive email messages and comprises a body 211 configured to be held in a text entry orientation by an operator or user. (For example, see Figures 2 and 3). The body 211 of the DUT 101 has a front face 200 at which a display 201 is located and upon which information is displayed to the operator of the DUT 101 in the text entry orientation. The DUT 101 further comprises a microprocessor configured to run programs on the DUT 101 and to receive operator commands from user inputs, such as a keyboard 207 and trackball 202, which can also be a trackpad, located on the DUT 101.

While the above description generally describes the systems and components associated with a handheld communication device, the DUT 101 could be another device such as a PDA, a laptop computer, desktop computer, a server, or other communication device. In those implementations, different components of the above system 100 might be omitted in order provide the desired testing system 100. Additionally, other components not described above may be required to allow the testing system 100 to function in a desired fashion. The above description provides only general components and additional components may be required to enable the testing system 100 to function. These systems and components would be appreciated by those of ordinary skill in the art.

The DUT 101 may include an auxiliary input that acts as a cursor navigation tool 202 and which can be exteriorly located upon the front face 200. The front face location of the auxiliary input that acts as a cursor navigation tool allows the cursor navigation tool to be easily thumb-actuable like the keys of the keyboard 207. An implementation provides the navigation tool 202 in the form of a trackball 202, which can be utilized to instruct two-dimensional screen cursor movement in substantially any direction, as well as act as an actuator when the trackball 202 is depressed like a button. The placement of the navigation tool 202 may be above the keyboard 207 and below the display 201; when above the keyboard 207 and below the display 201, the navigation tool avoids interference during keyboarding and does not block the operator's view of the display 201 during use, e.g., as shown in Figure 1.

As illustrated in Figures 2 and 3, the DUT 101 may be configured to send and receive messages. The DUT 101 includes a body 211, which may, in some implementations, be configured to be held in one hand by an operator of the DUT 101 during text entry. A display 201 is included which is located on a front face 200 of the body 211 and upon which information is displayed to the operator during text entry. The DUT 101 may also be configured to send and receive voice communications such as mobile telephone calls. The DUT 101 may also include a camera (not shown) to allow the user to take electronic photographs which can be referred to as photos or pictures.

In the exemplary implementations depicted in Figures 2 and 3, the display 201 can present barcodes representing test information to the detector 103 and the computer 105 to communicate, for example, the test being performed, information received and retransmitted to verify that the DUT 101 received the information properly by comparing the information sent to and returned from the DUT 101, the state of the DUT 101, or error information. The detector 103 can be a standard barcode reader or camera that is widely on the market. Corresponding software can be included to transmit the wireless test information such as a barcode 208 to the computer 105 that can process it.

Figure 3 illustrates a second example with the display 201 displaying the additional information as a QR code. Other implementations are also contemplated wherein the additional information can be sent using colors and other optical transmission signals such as words or pictures. Accordingly, more or less information can be transmitted in a single picture depending on the signal chosen because, for example, a QR barcode contains more information than a typical barcode 208 does. The DUT 101 can also transmit the additional information via infrared or ultraviolet signals. These and other frequencies of electromagnetic signals can be used as long as they do not interfere with the operative frequencies transmitted and received by the DUT 101. Additionally, information can be transmitted via sound waves instead of electromagnetic signals. The sound waves need not be audible to a human ear; for example, they may be only machine-understandable. It should be noted that all of these options, and similar options not stated herein, are important in that they do not require a cable to communicate to people or devices outside of the shielded testing chamber 110. Therefore, interference by the cable, typically containing some amount of metal, can be eliminated, thereby producing a superior testing environment.

The use of the display 201, or other transmitters, to emit electromagnetic signals obviates the use of a cable for the DUT 101 to communicate with the computer 105. Eliminating the cable has been found to be beneficial because the cable can have parasitic effects on the testing system 100. For example, the cable can change the electromagnetic field of the DUT 101 by changing the radiation pattern and impedance of the test antenna 105 or the antenna of the DUT 101; a change in the electromagnetic field of the DUT 101 can affect the antenna gain or the sensitivity of the antennas. A change in the electromagnetic field of the DUT 101 can cause variations of, for example, around +/-2dB signal gain which, as discussed above, can cause spurious passes (positive) and failures (negative) of tests. Moreover, signals sent over a metallic cable can create digital noise in the testing system 100. Using light and other lower-power electromagnetic signals does not cause distortion in the typically higher-power signals being tested. In addition, wireless communication over first and second frequencies allows for substantially concurrent communication on these two frequencies because they are sufficiently different from each other that test results will not be affected within tolerances allowed by the test.

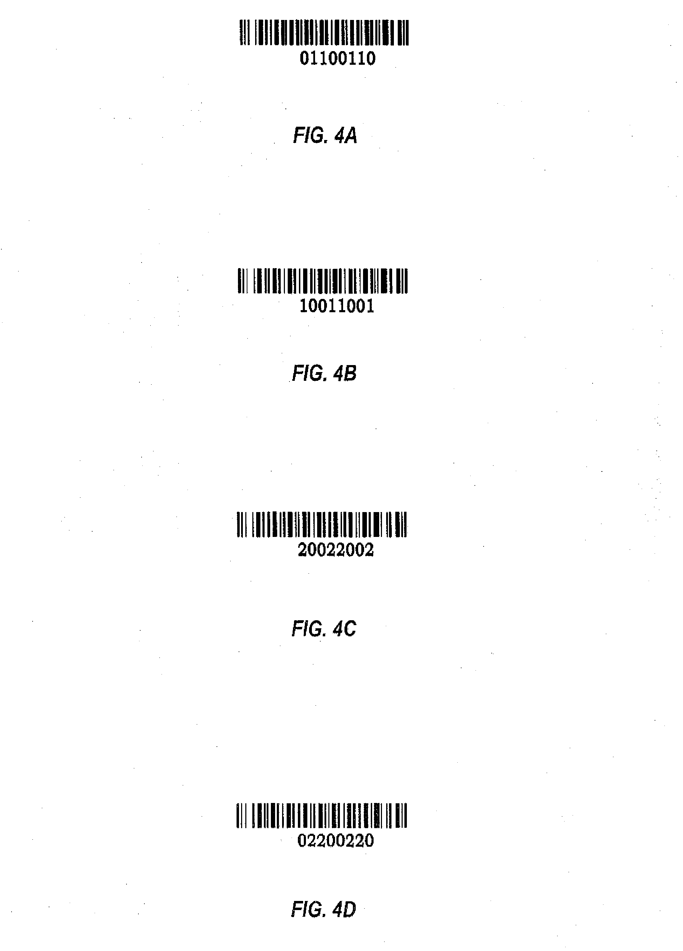

Barcodes can comprise a machine-readable series of numbers. These numbers can encode commands and status information as just described. Exemplary barcodes are illustrated in Figures 4A-4D, in which Figures 4A and 4B illustrate commands transmitted to the DUT 101, and Figures 4C and 4D illustrate status information transmitted from DUT 101. As illustrated in Figure 4A, a barcode 208 of 01100110 can represent a command to change the operating frequency of the DUT 101 and a barcode 208 of 10011001, as illustrated in Figure 4B, can represent a command to change the power level of the DUT 101. Likewise, a barcode 208 of 02200220, as illustrated in Figure 4C, can represent a status of the DUT 101 that a test has begun, and a barcode 208 of 20022002, as illustrated in Figure 4D, can represent a status that a test has completed. In other implementations, the DUT 101 can send similarly encoded information via an infrared port or other communication means.

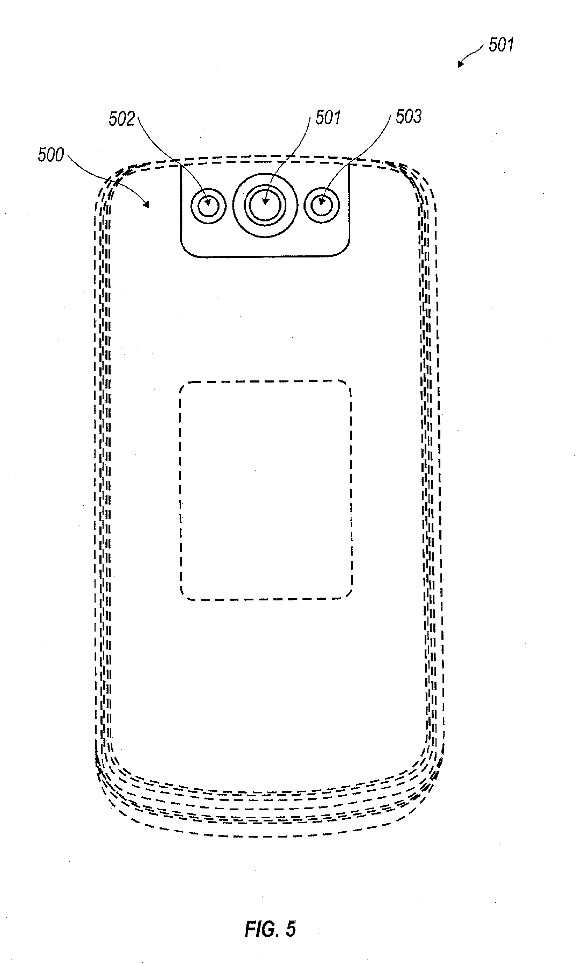

Figure 5 illustrates a back surface 500 of the DUT 101 with dashed lines to signify the topography or shape of the DUT 101. The back surface 500 can include a flash 503 for illuminating a subject in low-light conditions. The DUT 101 can include an ambient light detector 502, which can be used to automatically enable the flash 503 or change display brightness when a low-light condition is detected. The DUT 101 can also include a camera 501, which can be used to, for example, read instructions from the transmitter 104. Instructions can be communicated to the camera 501 in a similar manner as the additional information transmitted between the display 201 and the detector 103. The instructions can contain, for example, commands to be executed, instructions to begin a test suite, or commands to vary operational parameters, such as those illustrated in Figures 4A and 4B described above. Typically, the flash 503 will be disabled during testing to not interfere with the detector 103 when test information is being transmitted. The ambient light detector 502 can also be disabled to ensure that the brightness of the display 201 remains constant and consistent between tests.

In one example of a test that can be run in the testing system 100, the transmitter 104 can communicate a series of instructions to the camera 501 of the DUT 101. These instructions can include commands to change the operating frequency or power level (dBm) of the device. Software running on the DUT 101 can then begin executing instructions to perform a series of steps, such as attempting to make a phone call via the test antenna 102. The DUT 101 can communicate the state of operation of the DUT 101 via the barcode 208 on the display 201. The bar code can be read by the detector 103, which then can communicate the information to the computer 105, which can then vary the test, or send additional instructions to the DUT 101 via the transmitter 104. For example, the output power of the DUT 101 can be varied during a test. The absence of an additional cable in the shielded chamber 110 will prevent an incorrect power reading due to parasitic effects of the additional cable. Also, additional cables used in the testing system 100 can create electromagnetic radiation that can interfere with operations of the DUT 101 and other test signals. For example, information transmitted to and received from the DUT 101 can become distorted or scrambled due to interference from signals generated by additional cables with the shielded chamber 110. Therefore, any communication between the DUT 101 and computer 105 can benefit from the absence of additional cables within the shielded chamber 110.

Both the functionality to display barcodes and read barcodes can be implemented in software that is integral to the DUT 101 in an exemplar mobile device implementation. Incorporation of the ability to display and read barcodes in mobile devices can be advantageous. Applications using barcodes include reading merchandise barcodes on products in a traditional brick-and-mortar store to get reviews and price comparisons over the Internet. Another application can enable a user to read barcodes identifying web pages or software that the user would like to download to a mobile device. For example, a user may desire to download a mobile application, commonly referred to as an app. Instead of typing in identifying information, the user can simply scan a barcode 208 that identifies the app, which can then be downloaded to the mobile device. Similarly, the mobile device can display barcodes that other mobile devices or barcode scanners can interpret. A mobile device that can display barcodes that other mobile devices or barcode scanners can interpret can be useful to collect key-ring barcodes that people commonly carry to identify, for example, gym memberships or grocery store discount programs. In addition, a mobile device can display a barcode 208 that identifies a downloaded app that a different mobile device can read to download the same app. Still further applications for displaying barcodes can include passing information, such as a uniform resource locator (URL), from one mobile device to another, which would allow another mobile device to receive information without the need for a user to enter the URL using a keypad, either physical or software implemented. Therefore, the methods of reading and displaying information using a mobile device can provide value beyond the testing environment.

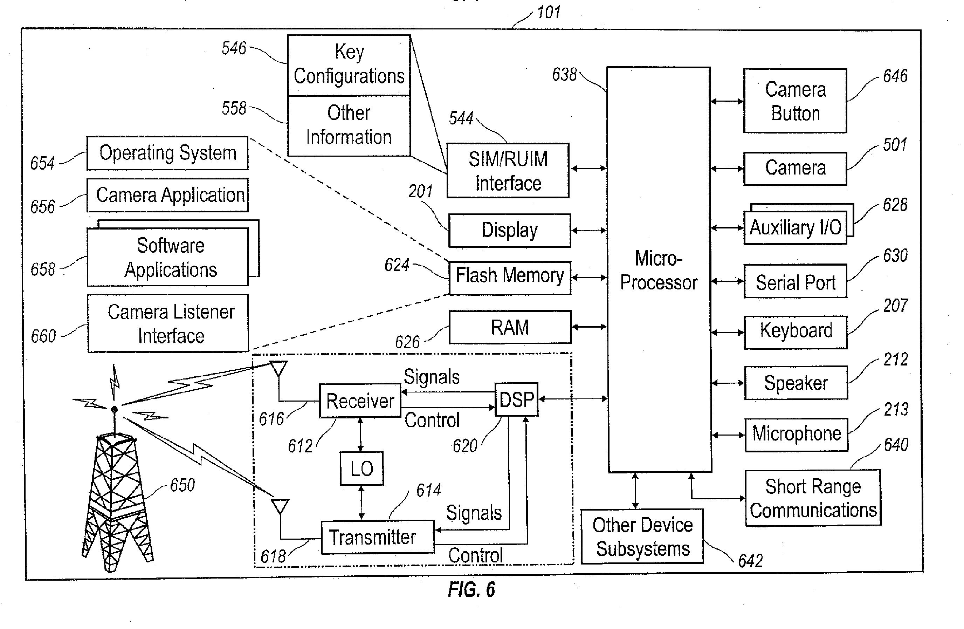

Referring again to the drawings, Figure 6 is a block diagram of a hand-held computing device to which the present disclosure is applied in an example implementation. In the example implementation, the DUT 101 is a two-way mobile communication device having data and possibly voice communication capabilities. In an example implementation, the device has the capability to communicate with other computer systems on the Internet. Depending on the functionality provided by the device, in various implementations the DUT 101 may be a data communication device, a multiple-mode communication device configured for both data and voice communication, a mobile telephone, a PDA (personal digital assistant) enabled for wireless communication, or a computer system with a wireless modem, among other things. In various implementations, the present disclosure may also be applied to handheld computing devices, such as PDAs and digital cameras that are not enabled for communications.

In the implementation depicted in Figure 6, in which the DUT 101 is enabled for communications, the DUT 101 includes a communication subsystem 611, including a receiver 612, a transmitter 614, and associated components such as one or more, potentially embedded or internal, antenna elements 616 and 618, and a processing module such as a digital signal processor (DSP) 620. In some implementations, the communication subsystem includes local oscillator(s) (LO) 613, and in some implementations the communication subsystem 611 and a microprocessor 638 share an oscillator. As will be apparent to those skilled in the field of communications, the particular design of the communication subsystem 611 will be dependent upon the communication network in which the device is intended to operate.

The two-way communication enabled DUT 101 can both transmit and receive information from the communication network 650. The transfer of communication can be from the DUT 101 or to the DUT 101. To communicate with the communication network 650, the DUT 101 in the presently described exemplary implementation is equipped with integral or internal antennae (616, 618) for transmitting messages to the communication network 650. Likewise, the DUT 101 in the presently described exemplary implementation can be equipped with another antenna (not shown) for receiving communication from the communication network 650. These antennae (616, 618), in another exemplary implementation, can be combined into a single antenna (not shown). As one skilled in the art would appreciate, the antenna or antennae (616, 618) in another implementation can be externally mounted on the DUT 101. The DUT 101 can also have a transmitter 614 and a receiver 612, which can be respectively communicatively coupled to antennae (616, 618), and can include one or more local oscillators 613 for processing the incoming or outgoing RF signals. The DUT 101 can also have a digital signal processor (DSP) 620 to assist in the processing of the incoming and outgoing signals.

Signals received by an antenna 616 through wireless a communication network 650 are input to a receiver 612, which may perform such common receiver functions as signal amplification, frequency down conversion, filtering, channel selection and the like, and in some implementations, analog to digital conversion. In a similar manner, signals to be transmitted are processed, including modulation and encoding for example, by the DSP 620 and input to the transmitter 614 for digital to analog conversion, frequency up conversion, filtering, amplification and transmission over the communications network 650 via the antenna 618.

The DUT 101 can include the microprocessor 638 to control the overall operation of the DUT 101. The microprocessor 638 can interact with the communications subsystem 611 and interact with further device subsystems such as the display 201, a flash memory 624, a random access memory (RAM) 626, an auxiliary input/output (I/O) subsystems 628, a serial port 630, the keyboard or keypad 207, the speaker 212, the microphone 213, a short-range communications subsystem 640, and any other device subsystems generally designated as 642. The DUT 101 of the present system can include integral camera 501 that interacts with the microprocessor 638. The DUT 101 can also include a dedicated camera button 646 for triggering operation of camera 501, as will be further described below. In some implementations, dedicated camera button 646 can be integrated within the keyboard or keypad 207.

In one exemplary implementation, the flash memory 624 can contain programs or apps for execution on the DUT 101 including an address book, a personal information manager (PIM), an app to display or read barcodes, browse the Internet, and any number of other applications that can take advantage of the features of the phone. Furthermore, programs and other information including data can be segregated upon storage in the flash memory 624 of DUT 101. Additional software applications can include email, contacts and calendars. For email, contacts and calendars, synchronization with home-based versions of the email, contacts and calendars, can be desirable for either or both of the long term utility of email, contacts and calendars, and the short term utility of email, contacts and calendars. As an example, emails are often time sensitive, so substantially real time (or near-real time) synchronization may be desired. Contacts, on the other hand, can be usually updated less frequently without inconvenience. Therefore, the utility of the communication device is enhanced when connectable within a communication system, and when connectable on a wireless basis in a network 219 in which voice, text messaging, and other data transfer are accommodated.

Some of the subsystems shown in Figure 6 can perform communication-related functions, whereas other subsystems can provide "resident" or on-device functions. Notably, some subsystems, such as keyboard 632 and display 201 can be used for both communication-related functions, such as entering a text message for transmission over a communication network, and device-resident functions such as a calculator or task list.

Operating system software 654 and various software applications 658 used by the microprocessor 638 are, in one example implementation, stored in a persistent store such as the flash memory 624 or similar storage element. Those skilled in the art will appreciate that the operating system 654, the software applications 658, or parts of operating system 654, or parts of the software applications 658, may be temporarily loaded into a volatile store such as the RAM 626. It is contemplated that received communication signals may also be stored to the RAM 626.

The microprocessor 638, in addition to the microprocessor's 638 operating system functions, enables execution of the software applications 658 on the DUT 101. A predetermined set of the software applications 658 which control basic device operations, including at least data and voice communication applications for example, will normally be installed on the DUT 101 during manufacture. Further software applications 658 may also be loaded onto the DUT 101 through the wireless antenna 650, the auxiliary I/O subsystem 628, the serial port 630, the short-range communications subsystem 640 or any other suitable subsystem 642, and installed by a user in the RAM 626 or a non-volatile store for execution by the microprocessor 638. Such flexibility in application installation increases the functionality of the device and may provide enhanced on-device functions, communication-related functions, or both. For example, secure communication applications may enable electronic commerce functions and other such financial transactions to be performed using the DUT 101.

In a data communication mode, a received signal such as a text message or web page download will be processed by the communication subsystem 611 and input to the microprocessor 638, which will possibly further process the received signal for output to the display 201, or alternatively to the auxiliary I/O device 628. A user of the DUT 101 may also compose data items within the software application 658, such as email messages for example, using the keyboard 207 in conjunction with the display 201 and possibly the auxiliary I/O device 628. Such composed items may then be transmitted over a communication network through the communication subsystem 611.

The serial port 630 in Figure 6 can be implemented in a personal digital assistant (PDA)-type communication device for which synchronization with a user's desktop computer (not shown) may be desirable, but is an optional device component. The serial port 630 would enable a user to set preferences through an external device or software application and would extend the capabilities of the device by providing information or software downloads to DUT 101 other than through a wireless communication network.

The short-range communications subsystem 640 is a further component which may provide for communication between the DUT 101 and different systems or devices, which need not necessarily be similar devices. For example, the subsystem 640 may include an infrared device and associated circuits and components or a Bluetooth^{™} communication module to provide for communication with similarly enabled systems and devices. The DUT 101 may be a handheld device.

The wireless mobile network 650 is, in an example implementation, a wireless packet data network, for example, Mobitex^{™} or DataTAC^{™}, which provides radio coverage to the DUT 101. The wireless mobile network 650 may also be a voice and data network can include, but are not limited to, the General Packet Radio Service (GPRS) network, the Universal Mobile Telecommunication Service (UMTS) network, the Enhanced Data for Global Evolution (EDGE) network, the Code Division Multiple Access (CDMA) network, High-Speed Packet Access (HSPA) networks, Universal Mobile Telecommunication Service Time Division Duplexing (UMTS-TDD), Ultra Mobile Broadband (UMB) networks, Worldwide Interoperability for Microwave Access (WiMAX) networks, Long Term Evolution (LTE) networks and other networks that can be used for data and voice, or just data or voice.

For the systems listed in the preceding paragraph, the DUT 101 can require a unique identifier to enable the DUT 101 to transmit and receive messages from the communication network 650. Other systems may not require such identifying information. As examples, GPRS, UMTS, and EDGE use a Subscriber Identity Module (SIM) in order to allow communication with the communication network 650. Likewise, most CDMA systems use a Removable User Identity Module (RUIM) to communicate with the CDMA network. The RUIM and SIM card can be used in multiple different DUTs 101. The DUT 101 can be able to operate some features without a SIM/RUIM card. A SIM/RUIM interface 644 located within the DUT 101 can allow for removal or insertion of a SIM/RUIM card (not shown). The SIM/RUIM card can feature memory and can hold key configurations 646, and other information 658, such as identification and subscriber related information. With a properly enabled the DUT 101, two-way communication between the DUT 101 and the communication network 650 is possible.

Portions of DUT 101 and supporting components can take the form of hardware elements, software elements or elements containing both hardware and software. In one implementation, the software portions can include, but are not limited to, firmware, resident software, microcode, etc. Furthermore, these software portions can take the form of a computer program product accessible from a computer-usable or computer-readable medium providing program code for use by or in connection with a computer or any instruction execution system. For the purposes of this disclosure, a computer-usable or computer readable medium can be any apparatus that can contain, store, communicate, propagate, or transport the program for use by or in connection with the instruction execution system, apparatus, or device. The medium can be an electronic, magnetic, optical, electromagnetic, infrared, or semiconductor system (or apparatus or device) or a propagation medium (though propagation mediums as signal carriers are not included in the definition of physical computer-readable medium). Examples of a physical computer-readable medium include a semiconductor or solid state memory, magnetic tape, a removable computer diskette, a random access memory (RAM), a read-only memory (ROM), a rigid magnetic disk and an optical disk. Current examples of optical disks include compact disk-read only memory (CD-ROM), compact disk-read/write (CD-R/W) and DVD. Both processors and program code for implementing each as aspect of the system can be centralized or distributed or centralized and distributed as known to those skilled in the art.

A data processing system suitable for storing program code and for executing program code, which can be implemented in any of the above-referenced devices described herein, can include at least one processor communicatively coupled directly or indirectly to a memory through a system bus. The memory elements can include local memory employed during actual execution of the program code, bulk storage, and cache memories that provide temporary storage of at least some program code in order to reduce the number of times code must be retrieved from bulk storage during execution. I/O devices (including but not limited to keyboards, displays, pointing devices, etc.) can be communicatively coupled to the system either directly or through intervening I/O controllers.

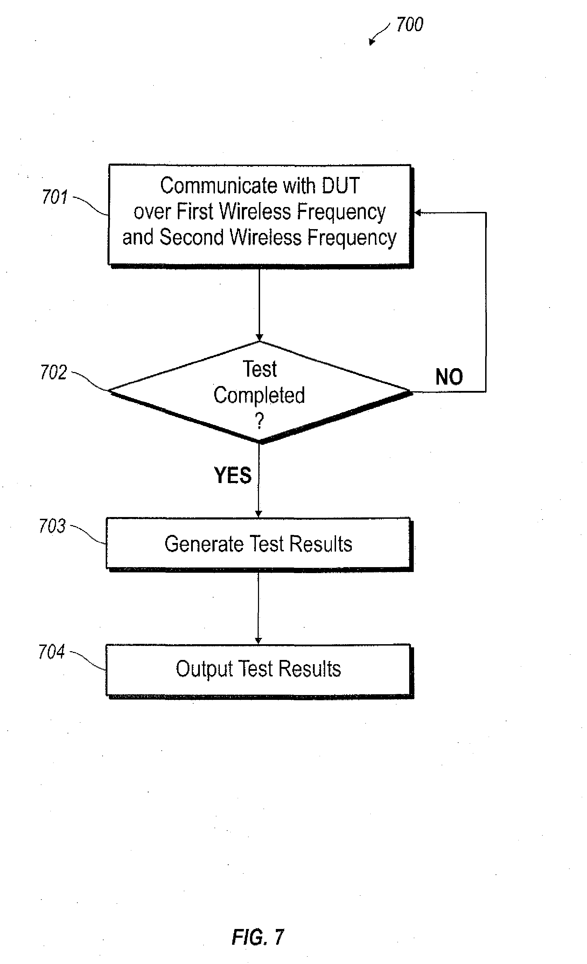

Figure 7 illustrates a method of verifying the operation of a DUT in accordance with an exemplary implementation. In the example depicted in Figure 7, at step 701, information can be communicated between the DUT and the computer over at least two different wireless frequencies, for example, GSM and optical frequencies. These different wireless frequencies can be communicated via, for example, the antennae (616, 618), the display 201, an infrared port or other similar wireless communication hardware. In step 702, if the test is not completed, the microprocessor 638 can continue executing a program until the test is completed and the method can proceed to step 703. In step 703, test results can be generated by a processor based on wireless information received and transmitted over at least the first and second wireless frequencies. Finally in step 704, the test results can be output to, for example, a memory or a display 201 associated with a processor for use in determining whether the DUT 101 passed or failed the test.

Other applications that could benefit from the implementations disclosed herein include regulatory tests required to verify that new products do not interfere with other products on the market. Products could be verified and tested in the field with, for example, a transportable shield chamber to test base stations. In addition, incorporation of barcode 208 and other communication software with the DUT 101 can be reused by an end user to read information or transmit information to other device.

In the preceding specification, various implementations have been described with reference to the accompanying drawings. Various modifications and changes can be made to the various implementations, and additional implementations can be implemented, without departing from the broader scope of the disclosure as set forth in the claims that follow. For example, instead of optical light being transmitted between the DUT 101 and the computer 105, infrared, ultraviolet, or other frequencies of electromagnetic light can be transmitted between the two. Electromagnetic light information or optical light information can be received serially, i.e., through pulsed light, or in parallel, for example in 2D or 3D barcodes. The specification and drawings are accordingly to be regarded in an illustrative rather than restrictive sense.

## Claims

1. A system (100) for verifying a device under test, DUT, (101) comprising:
a shielded testing chamber (110);
an antenna (102) configured for communicating with a DUT (101) within the shielded testing chamber using a first wireless communication at a first wireless frequency, the DUT including a camera (501);
a detector (103) configured for communicating with a DUT (101) within the shielded testing chamber using a second wireless communication at a second wireless frequency;
a transmitter (104) configured for transmitting a series of instructions to the camera (501) of the DUT via an optical signal, the camera (501) being configured to read the series of instructions;
a processor outside the shielded testing chamber and communicatively coupled to the antenna (102), to the detector (103), and to the transmitter (104), thereby obviating the need for a cable for communication between the DUT (101) and the processer, the processor configured to perform a wireless verification test for verifying DUT (101) operation and further configured to output test results to verify operation of the DUT (101) based on the first wireless communication, the second wireless communication, and the series of instructions;
wherein the DUT (101) is configured to output wireless test information in the form of a barcode displayed on a display (201) of the DUT (101), in response to the wireless verification test, the test information comprising at least one of test status information, operational parameters, and error information;
wherein the detector (103) comprises a barcode reader configured to read the barcode displayed on the display (201) of the DUT (101).

2. The system of claim 1, wherein the processor is further configured to compare at least one of a portion of the first wireless communication and a portion the second wireless communication to a predetermined value stored in a memory associated with the processor.

3. The system of claim 1 or 2, wherein the DUT (101) is further configured to transmit the first wireless communication and the second wireless communication substantially concurrently.

4. The system of claim 1, 2 or 3, wherein the first frequency is higher than the second frequency.

5. The system of claim 1, 2, 3 or 4, wherein the second frequency exists in a wireless spectrum selected from the group consisting of optical, infrared and ultraviolet.

6. A device under test, DUT, (101) comprising:
a processor configured to perform a wireless verification test for verifying DUT (101) operation and to provide wireless test information associated with the wireless verification test to an external detector (103);
a camera communicatively coupled to the processor, and configured to a read a series of instructions transmitted via an optical signal from a transmitter;
a wireless transceiver communicatively coupled to the processor and configured to communicate with an external antenna (102) via a first wireless frequency; and
an output communicatively coupled to the processor and configured to output the wireless test information to the external detector (103) via a second wireless frequency;
wherein the DUT (101) is configured to output wireless test information in the form of a barcode displayed on a display (201) of the DUT (101), in response to the wireless verification test, the test information comprising at least one of test status information, operational parameters, and error information;
wherein the external detector (103) comprises a barcode reader configured to read the barcode displayed on the display (201) of the DUT (101).

7. The DUT (101) of claim 6, wherein the second wireless frequency, and the series of instructions, do not interfere with the first wireless frequency to vary test results.

8. The DUT (101) of claim 6 or 7, wherein the DUT (101) is further configured communicate with the external antenna (102) substantially concurrently.

9. The DUT (101) of claim 6, 7, or 8, wherein the first wireless frequency is higher than the second wireless frequency.

10. The DUT (101) of claim 6. 7, 8, or 9, wherein the second wireless frequency exists in a wireless spectrum selected from the group consisting of optical, infrared and ultraviolet.

11. A computer-readable medium having a computer program for verifying wireless communication from a device under test, DUT, (101) comprising:
transmitting a series of instructions via an optical signal to a camera of the DUT, the camera configured to read the instructions;
performing a wireless test of the DUT (101), based on the instructions;
receiving a first wireless communication from the DUT (101) comprising a wireless packet;
receiving a second wireless communication from the DUT (101) comprising wireless test information in response to the wireless test of the DUT (101), the wireless test information being in the form of a barcode displayed on a display (201) of the DUT (101), the test information comprising at least one of test status information, operational parameters, and error information;
generating test results for verifying DUT (101) operation based on the wireless test information and the first wireless communication, wherein the wireless test information is different from the first wireless communication; and
outputting the test results to determine whether the DUT (101) satisfies test requirements.

12. The computer-readable medium of claim 11,
wherein first wireless communication and second wireless communication are transmitted to the computer program using different wireless frequencies;
wherein receiving the second wireless communication is transmitted to the computer program on a frequency in a wireless spectrum selected from the group consisting of optical, infrared and ultraviolet; and
wherein the second wireless frequency does not interfere with the first wireless frequency to vary test results.

13. The computer-readable medium of claim 11 or 12, wherein the DUT (101) receiving the first wireless communication and the second wireless communication occurs substantially concurrently and wherein the first wireless frequency is higher than the second wireless frequency.

14. The computer-readable medium of claim 11, 12, or 13, wherein the second wireless frequency exists in a spectrum selected from the group consisting of optical, infrared and ultraviolet.

## Patentansprüche

1. System (100) zum Überprüfen eines Prüflings (101) mit:
einer abgeschirmten Testkammer (110),
einer Antenne (102), die dazu konfiguriert ist, mit einem Prüfling (101) in der abgeschirmten Testkammer unter Verwendung einer ersten Drahtloskommunikation mit einer ersten Drahtlosfrequenz zu kommunizieren, wobei der Prüfling eine Kamera (501) aufweist,
einem Detektor (103), der dazu konfiguriert ist, mit einem Prüfling (101) in der abgeschirmten Testkammer unter Verwendung einer zweiten Drahtloskommunikation mit einer zweiten Drahtlosfrequenz zu kommunizieren,
einem Sender (104), der dazu konfiguriert ist, eine Folge von Anweisungen an die Kamera (501) des Prüflings über ein optisches Signal zu senden, wobei die Kamera (501) dazu konfiguriert ist, die Folge von Anweisungen zu lesen,
einem Prozessor, der außerhalb der geschützten Testkammer ist und der mit der Antenne (102), dem Detektor (103) und mit Sender (104) kommunikativ verbunden ist, wodurch ein Bedarf für ein Kabel zur Kommunikation zwischen dem Prüfling (101) und dem Prozessor vermieden wird, wobei der Prozessor dazu konfiguriert ist, einen Drahtlosüberprüfungstest zum Überprüfen des Prüflings- (101) Betriebs durchzuführen, und ferner dazu konfiguriert ist, Testergebnisse auszugeben, um auf Grundlage der ersten Drahtloskommunikation, der zweiten Drahtloskommunikation und der Folge von Anweisungen einen Betrieb des Prüflings (101) zu überprüfen,
wobei der Prüfling (101) dazu konfiguriert ist, eine Drahtlostestinformation in Form eines Barcodes, der auf einer Anzeige (201) des Prüflings (101) angezeigt wird, als Reaktion auf den Drahtlosüberprüfungstest auszugeben, wobei die Testinformation mindestens eines von einer Teststatusinformation, Betriebsparametern und einer Fehlerinformation aufweist,
wobei der Detektor (103) einen Barcodeleser aufweist, der dazu konfiguriert ist, den Barcode zu lesen, der auf der Anzeige (201) des Prüflings (101) angezeigt wird.

2. System nach Anspruch 1, wobei der Prozessor ferner dazu konfiguriert ist, mindestens einen von einem Teil der ersten Drahtloskommunikation und einem Teil der zweiten Drahtloskommunikation mit einem vorbestimmten Wert zu vergleichen, der in einem Speicher gespeichert ist, der mit dem Prozessor verknüpft ist.

3. System nach Anspruch 1 oder 2, wobei der Prüfling (101) ferner dazu konfiguriert ist, die erste Drahtloskommunikation und die zweite Drahtloskommunikation im Wesentlichen gleichzeitig zu senden.

4. System nach einem der Ansprüche 1 bis 3, wobei die erste Frequenz höher als die zweite Frequenz ist.

5. System nach einem der Ansprüche 1 bis 4, wobei die zweite Frequenz in einem Drahtlosspektrum existiert, das aus der Gruppe ausgewählt ist, die aus optisch, infrarot und ultraviolett besteht.

6. Prüfling (101) mit:
einem Prozessor, der dazu konfiguriert ist, einen Drahtlosüberprüfungstest zum Überprüfen eines Prüflings- (101) Betriebs durchzuführen und Drahtlostestinformation, die mit dem Drahtlosüberprüfungstest verknüpft ist, einem externen Detektor (103) zu bereitzustellen,
einer Kamera, die mit dem Prozessor kommunikativ verbunden ist und die dazu konfiguriert ist, eine Folge von Anweisungen zu lesen, die über ein optisches Signal von einem Sender gesendet sind,
einem Drahtlos-Sende-Empfänger, der mit dem Prozessor kommunikativ verbunden ist und der dazu konfiguriert ist, mit einer externen Antenne (102) über eine erste Drahtlosfrequenz zu kommunizieren, und
einem Ausgang, der mit dem Prozessor kommunikativ verbunden ist und der dazu konfiguriert ist, die Drahtlostestinformation an den externen Detektor (103) über eine zweite Drahtlosfrequenz auszugeben,
wobei der Prüfling (101) dazu konfiguriert ist, Drahtlostestinformation in Form eines Barcodes, der auf einer Anzeige (201) des Prüflings (101) angezeigt wird, als Reaktion auf den Drahtlosüberprüfungstest auszugeben, wobei die Testinformation mindestens eines von einer Teststatusinformation, Betriebsparametern und einer Fehlerinformation aufweist,
wobei der externe Detektor (103) einen Barcodeleser aufweist, der dazu konfiguriert ist, den Barcode zu lesen, der auf der Anzeige (201) des Prüflings (101) angezeigt wird.

7. Prüfling (101) nach Anspruch 6, wobei die zweite Drahtlosfrequenz und die Folge von Anweisungen mit der ersten Drahtlosfrequenz nicht interferieren, um Testergebnisse zu variieren.

8. Prüfling (101) nach Anspruch 6 oder 7, wobei der Prüfling (101) ferner dazu konfiguriert ist, im Wesentlichen gleichzeitig mit der externen Antenne (102) zu kommunizieren.

9. Prüfling (101) nach einem der Ansprüche 6 bis 8, wobei die erste Drahtlosfrequenz höher als die zweite Drahtlosfrequenz ist.

10. Prüfling (101) nach einem der Ansprüche 6 bis 9, wobei die erste Drahtlosfrequenz in einem Drahtlosspektrum existiert, das aus der Gruppe ausgewählt ist, die aus optisch, infrarot und ultraviolett besteht.

11. Computerlesbares Medium, das ein Computerprogramm zum Überprüfen einer Drahtloskommunikation von einem Prüfling (101) aufweist, mit:
Senden einer Folge von Anweisungen über ein optisches Signal an eine Kamera des Prüflings, wobei die Kamera dazu konfiguriert ist, die Anweisungen zu lesen,
Durchführen eines Drahtlostests des Prüflings (101) auf Grundlage der Anweisungen,
Empfangen einer ersten Drahtloskommunikation von dem Prüfling (101) mit einem Drahtlospaket,
Empfangen einer zweiten Drahtloskommunikation von dem Prüfling (101) mit Drahtlostestinformation als Reaktion auf den Drahtlostest des Prüflings (101), wobei die Drahtlostestinformation in Form eines Barcodes ist, der auf einer Anzeige (201) des Prüflings (101) angezeigt wird, wobei die Testinformation mindestens eines von einer Teststatusinformation, Betriebsparametern und einer Fehlerinformation aufweist,
Erzeugen von Testergebnissen zum Überprüfen eines Prüflings- (101) Betriebs auf Grundlage der Drahtlostestinformation und der ersten Drahtloskommunikation, wobei die Drahtlostestinformation von der ersten Drahtloskommunikation verschieden ist, und
Ausgeben der Testergebnisse, um zu bestimmen, ob der Prüfling (101) Testerfordernissen genügt.

12. Computerlesbares Medium nach Anspruch 11,
wobei die erste Drahtloskommunikation und die zweite Drahtloskommunikation an das Computerprogramm unter Verwendung von verschiedenen Drahtlosfrequenzen gesendet werden,
wobei ein Empfangen der zweiten Drahtloskommunikation bzw., die zweite Drahtloskommunikation empfangend, bzw. die zweite Drahtloskommunikation an das Computerprogramm auf einer Frequenz in einem Drahtlosspektrum gesendet wird, das aus der Gruppe ausgewählt ist, die aus optisch, infrarot und ultraviolett besteht, und
wobei die zweite Drahtlosfrequenz mit der ersten Drahtlosfrequenz nicht interferiert, um die Testergebnisse zu variieren.

13. Computerlesbares Medium nach Anspruch 11 oder 12, wobei im Wesentlichen gleichzeitig geschieht, dass der Prüfling (101) die erste Drahtloskommunikation und die zweite Drahtloskommunikation empfängt, und wobei die erste Drahtlosfrequenz höher als die zweite Drahtlosfrequenz ist.

14. Computerlesbares Medium nach einem der Ansprüche 11 bis 13, wobei die zweite Drahtlosfrequenz in einem Spektrum existiert, das aus der Gruppe gewählt ist, die aus optisch, infrarot und ultraviolett besteht.

## Revendications

1. Système (100) pour vérifier un dispositif en cours de test, DUT, (101) comprenant :
une enceinte d'essai blindée (110) ;
une antenne (102) configurée pour communiquer avec un DUT (101) à l'intérieur de l'enceinte d'essai blindée en utilisant une première communication sans fil à une première fréquence sans fil, le DUT comprenant un appareil photo (501) ;
un détecteur (103) configuré pour communiquer avec un DUT (101) à l'intérieur de l'enceinte d'essai blindée en utilisant une seconde communication sans fil à une seconde fréquence sans fil ;
un transmetteur (104) configuré pour transmettre une série d'instructions à l'appareil photo (501) du DUT via un signal optique, l'appareil photo (501) étant configuré pour lire la série d'instructions ;
un processeur à l'extérieur de l'enceinte d'essai blindée et couplé de manière communicative à l'antenne (102), au détecteur (103), et au transmetteur (104), évitant ainsi le besoin d'un câble pour la communication entre le DUT (101) et le processeur, le processeur configuré pour effectuer un test de vérification sans fil pour vérifier le fonctionnement du DUT (101) et en outre configuré pour sortir des résultats de test pour vérifier le fonctionnement du DUT (101) sur la base de la première communication sans fil, de la seconde communication sans fil, et de la série d'instructions ;
dans lequel le DUT (101) est configuré pour sortir des informations de test sans fil sous la forme d'un code à barres affiché sur un afficheur (201) du DUT (101), en réponse au test de vérification sans fil, les informations de test comprenant au moins un parmi des informations de statut de test, des paramètres opérationnels, et des informations d'erreur ;
dans lequel le détecteur (103) comprend un lecteur de code à barres configuré pour lire le code à barres affiché sur l'afficheur (201) du DUT (101).

2. Système selon la revendication 1, dans lequel le processeur est en outre configuré pour comparer au moins une d'une partie de la première communication sans fil et d'une partie de la seconde communication sans fil à une valeur prédéterminée stockée dans une mémoire associée au processeur.

3. Système selon la revendication 1 ou 2, dans lequel le DUT (101) est en outre configuré pour transmettre la première communication sans fil et la seconde communication sans fil sensiblement simultanément.

4. Système selon la revendication 1, 2 ou 3, dans lequel la première fréquence est supérieure à la seconde fréquence.

5. Système selon la revendication 1, 2, 3 ou 4, dans lequel la seconde fréquence existe dans un spectre sans fil sélectionné dans le groupe constitué par optique, infrarouge et ultraviolet.

6. Dispositif en cours de test, DUT, (101) comprenant :
un processeur configuré pour effectuer un test de vérification sans fil pour vérifier le fonctionnement du DUT (101) et pour fournir des informations de test sans fil associées au test de vérification sans fil à un détecteur externe (103) ;
un appareil photo couplé de manière communicative au processeur, et configuré pour lire une série d'instructions transmise via un signal optique depuis un transmetteur ;
un émetteur-récepteur sans fil couplé de manière communicative au processeur et configuré pour communiquer avec une antenne externe (102) via une première fréquence sans fil ; et
une sortie couplée de manière communicative au processeur et configurée pour sortir les informations de test sans fil vers le détecteur externe (103) via une seconde fréquence sans fil ;
dans lequel le DUT (101) est configuré pour sortir des informations de test sans fil sous la forme d'un code à barres affiché sur un afficheur (201) du DUT (101), en réponse au test de vérification sans fil, les informations de test comprenant au moins un parmi des informations de statut de test, des paramètres opérationnels, et des informations d'erreur ;
dans lequel le détecteur externe (103) comprend un lecteur de code à barres configuré pour lire le code à barres affiché sur l'afficheur (201) du DUT (101).

7. DUT (101) selon la revendication 6, dans lequel la seconde fréquence sans fil, et la série d'instructions, n'interfèrent pas avec la première fréquence sans fil pour faire varier des résultats de test.

8. DUT (101) selon la revendication 6 ou 7, dans lequel le DUT (101) est en outre configuré pour communiquer avec l'antenne externe (102) sensiblement simultanément.

9. DUT (101) selon la revendication 6, 7 ou 8, dans lequel la première fréquence sans fil est supérieure à la seconde fréquence sans fil.

10. DUT (101) selon la revendication 6 7, 8 ou 9, dans lequel la seconde fréquence sans fil existe dans un spectre sans fil sélectionné dans le groupe constitué par optique, infrarouge et ultraviolet.

11. Support lisible par ordinateur ayant un programme informatique pour vérifier une communication sans fil à partir d'un dispositif en cours de test, DUT, (101) comprenant :
la transmission d'une série d'instructions via un signal optique à un appareil photo du DUT, l'appareil photo configuré pour lire les instructions ;
l'exécution d'un test sans fil du DUT (101), sur la base des instructions ;
la réception d'une première communication sans fil en provenance du DUT (101) comprenant un paquet sans fil ;
la réception d'une seconde communication sans en provenance du DUT (101) comprenant des informations de test sans fil en réponse au test sans fil du DUT (101), les informations de test sans fil étant sous la forme d'un code à barres affiché sur un afficheur (201) du DUT (101), les informations de test comprenant au moins un parmi des informations de statut de test, des paramètres opérationnels, et des informations d'erreur ;
la génération de résultats de test pour vérifier le fonctionnement du DUT (101) sur la base des informations de test sans fil et de la première communication sans fil, où les informations de test sans fil sont différentes de la première communication sans fil ; et
la sortie des résultats de test pour déterminer si le DUT (101) satisfait à des exigences de test.

12. Support lisible par ordinateur selon la revendication 11,
dans lequel la première communication sans fil et la seconde communication sans fil sont transmises au programme informatique en utilisant des fréquences sans fil différentes ;
dans lequel la réception de la seconde communication sans fil est transmise au programme informatique sur une fréquence dans un spectre sans fil sélectionné dans le groupe constitué par optique, infrarouge et ultraviolet ; et
dans lequel la seconde fréquence sans fil n'interfère pas avec la première fréquence sans fil pour faire varier des résultats de test.

13. Support lisible par ordinateur selon la revendication 11 ou 12, dans lequel le DUT (101) recevant la première communication sans fil et la seconde communication sans fil se produit sensiblement simultanément et dans lequel la première fréquence sans fil est supérieure à la seconde fréquence sans fil.

14. Support lisible par ordinateur selon la revendication 11, 12 ou 13, dans lequel la seconde fréquence sans fil existe dans un spectre sélectionné dans le groupe constitué par optique, infrarouge et ultraviolet.
